# DEMANDE DE BREVET EUROPEEN

(11) **EP 3 287 795 A1**
(43) Date de publication de la demande: **28.02.2018**
(21) Numéro de dépôt: 17186988.6
(22) Date de dépôt: 21.08.2017
(51) Int. Cl.: G01R 23/02, G01R 23/15, H02H 3/46

(54) **DETERMINATION DE LA FREQUENCE D'UN SIGNAL ALTERNATIF**

(30) Priorité: 24.08.2016 FR 1657892
(71) Demandeur: Schneider Electric Industries SAS, 92500 Rueil-Malmaison (FR)
(72) Inventeur: MECREANT, Julien, 38050 GRENOBLE Cedex 9 (FR); GHAFARI, Christophe, 38050 GRENOBLE Cedex 9 (FR); RAISON, Bertrand, 38050 GRENOBLE Cedex 9 (FR); CAIRE, Raphaël, 38050 GRENOBLE Cedex 9 (FR)
(74) Mandataire: Brevalex

(57) **Abrégé**

Procédé de détermination de la fréquence d'un signal d'entrée alternatif, comportant les étapes de :
Mémorisation (E1) du signal d'entrée,
Echantillonnage (E3) du signal d'entrée à une première fréquence d'échantillonnage,
Premier calcul et première comparaison angulaire (E4, E5) de deux phaseurs représentant le signal d'entrée à deux instants respectifs décalés d'une durée prédéterminée, en fonction du signal d'entrée échantillonné à la première fréquence d'échantillonnage,
Estimation (E5) de la fréquence du signal d'entrée,
Recherche (E6) d'une modification de fréquence du signal d'entrée, et en cas de détection d'une modification,
Détermination (E7) d'une seconde fréquence d'échantillonnage,
Echantillonnage (E3) du signal d'entrée mémorisé avec la seconde fréquence d'échantillonnage, sur une fenêtre temporelle précédant l'instant de détection de modification de fréquence,
Second calcul et seconde comparaison angulaire (E4, E5) de deux phaseurs représentant le signal d'entrée, à deux instants respectifs décalés de la durée prédéterminée, en fonction du signal d'entrée échantillonné à la seconde fréquence d'échantillonnage et du signal d'entrée mémorisé échantillonné à la seconde fréquence d'échantillonnage,
Estimation (E5) de la fréquence du signal d'entrée.

## Description

### DOMAINE TECHNIQUE

La présente invention concerne la détermination de la fréquence d'un signal électrique alternatif et le cas échéant la détermination de la dérivée de cette fréquence.

Cette détermination est par exemple mise en oeuvre dans un relais de protection électrique ou un équipement de télé-conduite de réseau de distribution électrique. Un relais de protection est destiné à protéger les personnes et équipements d'un réseau électrique. Un équipement de télé-conduite est destiné à assurer, dans les sous-stations, des mesures et des opérations de contrôle-commande de manière distante, grâce à des moyens de communication appropriés. Pour assurer ces fonctions, le relais ou l'équipement de télé-conduite doit être précis en phase et en amplitude, ce qui implique notamment que la fréquence du courant électrique alternatif de l'installation à protéger doit être déterminée avec précision.

### ÉTAT DE LA TECHNIQUE ANTÉRIEURE

Le fonctionnement de la plupart des relais de protection numériques ou des équipements de télé-conduite est basé sur un calcul de la transformée de Fourier discrète (TFD) d'un signal temporel afin d'extraire uniquement la composante fondamentale du signal (harmonique de rang 1). Ce signal temporel représente un courant électrique ou une tension électrique.

Le calcul par transformée de Fourrier Discrète suppose que le signal temporel est préalablement échantillonné.

Pour assurer les meilleures précisions possibles en termes d'amplitude, d'angles, mais aussi en termes de mesure de fréquence et de mesure de dérivée de fréquence du signal électrique, la fréquence d'échantillonnage doit être synchrone à la fréquence du signal électrique. En d'autres termes, la fréquence d'échantillonnage doit être un multiple de la fréquence du signal. Cette synchronisation est nommée asservissement de fréquence d'échantillonnage.

Cette méthode de calcul par transformée de Fourier trouve ses limites de précision lorsque la fréquence d'échantillonnage n'est pas synchrone à la fréquence du signal électrique alternatif. Par exemple, le réseau d'alimentation électrique a une fréquence théorique de 50Hz +/-0.5Hz en France en conditions normales de fonctionnement. Cette fréquence théorique est l'image de l'équilibre entre production et consommation. En pratique, la valeur réelle de fréquence fluctue continuellement dans cette bande passante admissible, mais peut dans certaines situations présenter des variations plus importantes. Il est nécessaire de prendre en compte toutes ces fluctuations, tant sur la gestion du réseau que sur l'exploitation des mesures faites par les équipements sur le réseau.

De plus, lors de certaines phases transitoires, les variations par rapport au nominal peuvent être encore plus importantes, par exemple lorsqu'un générateur est en phase de démarrage ou encore lorsque certaines charges de puissance élevée, telles que dans l'industrie électro-intensive, sont enclenchées.

Il est connu de calculer la fréquence d'une grandeur électrique, notamment une tension ou un courant réseau, sur la base de l'écart angulaire entre deux phaseurs calculés à des instants différents, c'est-à-dire décalés d'une durée donnée. Cette technique est connue sous le nom de méthodes des phaseurs. Les phaseurs sont de préférence des phaseurs de tension ou en variante des phaseurs d'intensité. Cet écart angulaire est l'image de la fréquence de la grandeur électrique. Cette méthode est basée sur le calcul de la TFD, qui est déjà calculée dans le relais pour les fonctions de protection ou dans l'équipement de télé-conduite pour des fonctions de mesure.

Or, lorsque la fréquence de la grandeur électrique est modifiée, par exemple suite à une modification de l'équilibre production/consommation, la fréquence d'échantillonnage est modifiée afin qu'elle demeure synchrone avec la fréquence de la grandeur électrique. Lors des changements de fréquence d'échantillonnage, le calcul de la fréquence et de la dérivée de la fréquence est erroné pendant une période transitoire, car les phaseurs sont eux-mêmes erronés. Ces valeurs erronées sont préjudiciables aux fonctions de protection ou à celles des équipements de télé-conduite qui demandent une précision de plus en plus élevée. Ces valeurs erronées doivent donc être supprimées, au risque de dégrader les temps de déclenchement des protections de fréquence et de dérivée de la fréquence ou de dégrader les mesures de tension, courant, puissance ou énergie transitant au niveau de la sous-station où se trouve l'équipement de télé-conduite. En outre, l'asservissement de fréquence d'échantillonnage, basé sur le calcul de la fréquence du courant électrique, est également erroné lors de la mise à jour de la fréquence d'échantillonnage.

### EXPOSÉ DE L'INVENTION

L'invention vise à résoudre les problèmes de la technique antérieure en fournissant un procédé de détermination de la fréquence d'un signal d'entrée alternatif, comportant les étapes de :
Echantillonnage du signal d'entrée à une première fréquence d'échantillonnage,
Premier calcul et première comparaison angulaire de deux phaseurs représentant le signal d'entrée à deux instants respectifs décalés d'une durée prédéterminée, en fonction du signal d'entrée échantillonné à la première fréquence d'échantillonnage,
Estimation de la fréquence du signal d'entrée en fonction du résultat de la comparaison angulaire des deux phaseurs calculés,
caractérisé en ce qu'il comporte en outre les étapes de :
   Mémorisation du signal d'entrée,
   Recherche d'une modification de fréquence du signal d'entrée,
   et en cas de détection d'une modification de fréquence du signal d'entrée,
Détermination d'une seconde fréquence d'échantillonnage, en fonction de la fréquence modifiée du signal d'entrée,
Echantillonnage du signal d'entrée mémorisé avec la seconde fréquence d'échantillonnage, sur une fenêtre temporelle précédant l'instant de détection de modification de fréquence,
Second calcul et seconde comparaison angulaire de deux phaseurs représentant le signal d'entrée, à deux instants respectifs décalés de la durée prédéterminée, en fonction du signal d'entrée échantillonné à la seconde fréquence d'échantillonnage et du signal d'entrée mémorisé échantillonné à la seconde fréquence d'échantillonnage,
Estimation de la fréquence du signal d'entrée en fonction du résultat de la seconde comparaison angulaire des deux phaseurs calculés.

Grâce à l'invention, un changement de fréquence d'échantillonnage dû au changement de la fréquence du signal électrique alternatif n'a pas d'effet négatif sur la mesure de la fréquence du signal électrique alternatif. En effet, les données prises en compte dans les calculs, notamment ceux de comparaison, sont échantillonnées avec une même fréquence d'échantillonnage.

Selon une caractéristique préférée, la mémorisation du signal d'entrée est effectuée sur une fenêtre temporelle glissante d'une durée au moins égale à la somme du décalage temporel entre deux phaseurs qui sont comparés et de la profondeur de calcul d'un phaseur.

Selon une caractéristique préférée, la recherche d'une modification de fréquence du signal d'entrée comporte le calcul d'une différence entre deux valeurs successives de la fréquence estimée du signal d'entrée, et la comparaison de la différence calculée à un seuil.

Selon une caractéristique préférée, le procédé de détermination de la fréquence d'un signal d'entrée alternatif comporte en outre le calcul de la dérivée de la fréquence du signal d'entrée.

Selon une caractéristique préférée, la durée prédéterminée pour le calcul et la comparaison de deux phaseurs est d'une demi-période du signal d'entrée.

Selon une caractéristique préférée, le calcul et la comparaison de deux phaseurs sont effectués tous les quarts de période du signal d'entrée.

Selon une caractéristique préférée, le signal d'entrée représente le courant ou la tension d'un réseau d'alimentation électrique.

Selon une autre caractéristique préférée, le signal d'entrée représente une composante de courant ou de tension d'un réseau d'alimentation électrique, cette composante étant issue d'une transformation matricielle du courant ou de la tension du réseau d'alimentation électrique.

L'invention concerne aussi un dispositif de détermination de la fréquence d'un signal d'entrée alternatif, comportant :
Des moyens d'échantillonnage du signal d'entrée à une première fréquence d'échantillonnage,
Des moyens de premier calcul et première comparaison angulaire de deux phaseurs représentant le signal d'entrée à deux instants respectifs décalés d'une durée prédéterminée, en fonction du signal d'entrée échantillonné à la première fréquence d'échantillonnage,
Des moyens d'estimation de la fréquence du signal d'entrée en fonction du résultat de la comparaison angulaire des deux phaseurs calculés,
caractérisé en ce qu'il comporte en outre :
   Des moyens de mémorisation du signal d'entrée,
   Des moyens de recherche d'une modification de fréquence du signal d'entrée,
   Des moyens de détermination d'une seconde fréquence d'échantillonnage, en fonction de la fréquence modifiée du signal d'entrée, en cas de détection d'une modification de fréquence du signal d'entrée,
   Des moyens d'échantillonnage du signal d'entrée mémorisé avec la seconde fréquence d'échantillonnage, sur une fenêtre temporelle précédant l'instant de détection de modification de fréquence,
   Des moyens de second calcul et seconde comparaison angulaire de deux phaseurs représentant le signal d'entrée, à deux instants respectifs décalés de la durée prédéterminée, en fonction du signal d'entrée échantillonné à la seconde fréquence d'échantillonnage et du signal d'entrée mémorisé échantillonné à la seconde fréquence d'échantillonnage,
   Des moyens d'estimation de la fréquence du signal d'entrée en fonction du résultat de la seconde comparaison angulaire des deux phaseurs calculés.

L'invention concerne encore un relais de protection caractérisé en ce qu'il comporte le dispositif de détermination de la fréquence d'un signal d'entrée alternatif précédemment présenté.

L'invention concerne encore un équipement de télé-conduite de réseau de distribution électrique caractérisé en ce qu'il comporte le dispositif de détermination de la fréquence d'un signal d'entrée alternatif précédemment présenté.

Le dispositif, le relais et l'équipement de télé-conduite de réseau de distribution électrique présentent des avantages analogues à ceux précédemment présentés.

Dans un mode particulier de réalisation, les étapes du procédé selon l'invention sont mises en oeuvre par des instructions de programme d'ordinateur.

En conséquence, l'invention vise aussi un programme d'ordinateur sur un support d'informations, ce programme étant susceptible d'être mis en oeuvre dans un ordinateur, ce programme comportant des instructions adaptées à la mise en oeuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en oeuvre des étapes d'un procédé tel que décrit ci-dessus.

Le support d'informations peut être n'importe quelle entité ou dispositif capable de stocker le programme.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

### BRÈVE DESCRIPTION DES DESSINS

D'autres caractéristiques et avantages apparaîtront à la lecture de la description suivante d'un mode de réalisation préféré, donné à titre d'exemple non limitatif, décrit en référence aux figures dans lesquelles :
La figure 1 représente un dispositif de détermination de la fréquence d'un signal électrique alternatif selon la technique antérieure ;
La figure 2 représente un dispositif de détermination de la fréquence d'un signal électrique alternatif selon un mode de réalisation de la présente invention ;
La figure 3a représente un signal échantillonné avant mise en oeuvre de l'invention ;
La figure 3b représente un signal échantillonné après mise en oeuvre de l'invention ;
La figure 4a représente un exemple de variation de la fréquence du signal électrique alternatif, selon la technique antérieure ;
La figure 4b représente un exemple de variation de la fréquence du signal électrique alternatif, selon la présente invention ;
La figure 5a représente un exemple de variation de la dérivée de la fréquence du signal électrique alternatif, selon la technique antérieure ;
La figure 5b représente un exemple de variation de la dérivée de la fréquence du signal électrique alternatif, selon la présente invention ;
La figure 6 représente un procédé de détermination de la fréquence d'un signal électrique alternatif selon un mode de réalisation de la présente invention ;
La figure 7 représente un mode de réalisation du dispositif de détermination de la fréquence d'un signal électrique alternatif selon la présente invention.

### EXPOSÉ DÉTAILLÉ DE MODES DE RÉALISATION PARTICULIERS

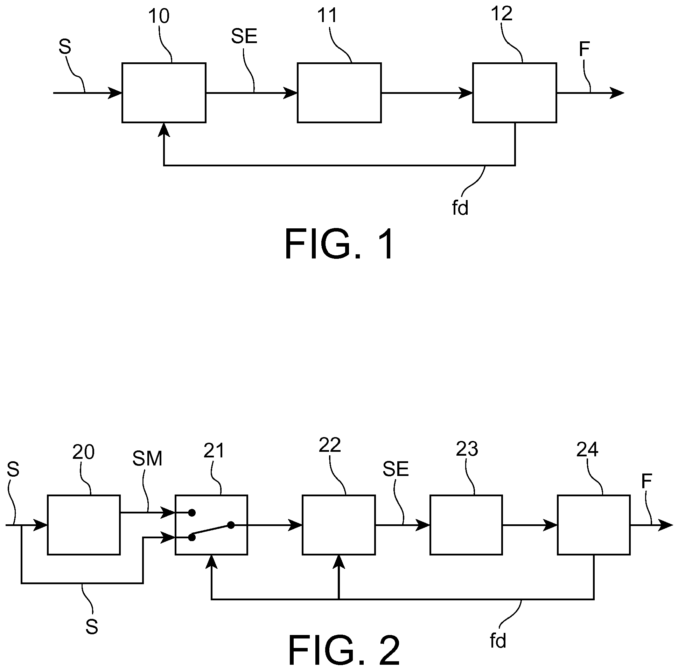

La **figure 1** représente un dispositif de détermination de la fréquence d'un signal électrique alternatif selon la technique antérieure. Ce dispositif est par exemple mis en oeuvre dans un relais de protection. Les relais de protection destinés à protéger les personnes et équipements d'un réseau d'alimentation électrique doivent être précis en phase et en amplitude.

Seuls les éléments utiles à la compréhension de l'invention seront décrits.

Le dispositif de détermination de la fréquence d'un signal électrique alternatif comporte une entrée pour recevoir un signal d'entrée S sous la forme d'un signal numérique échantillonné à une fréquence d'échantillonnage donnée, par exemple 4800 Hz. Le signal numérique est un signal de courant électrique alternatif, ou un signal de tension électrique alternatif.

En variante, la fréquence d'échantillonnage du signal peut être variable.

Selon une autre variante, les traitements qui vont être décrits sont effectués sur un signal préalablement transformé. Par exemple, dans un système multiphasé, une représentation matricielle des signaux est utilisée avec une transformée de Clarke, de Park ou de Fortescue. Le signal considéré représente alors une composante de courant ou de tension d'un réseau d'alimentation électrique, cette composante étant issue d'une transformation matricielle du courant ou de la tension du réseau d'alimentation électrique.

L'entrée du dispositif est reliée à un module de sous-échantillonnage 10 qui réalise un sous-échantillonnage sur le signal d'entrée S qu'il reçoit. Le sous-échantillonnage est asservi en fréquence et permet de passer d'un signal numérique échantillonné à une fréquence d'échantillonnage donnée, par exemple 4800 Hz, à un signal numérique ré-échantillonné SE comportant un nombre déterminé de points, par exemple 48, par période du signal d'entrée. La fréquence de sous-échantillonnage fd dépend de la fréquence du signal d'entrée. Ces deux fréquences sont dites en adéquation si la fréquence de sous-échantillonnage permet d'obtenir le nombre souhaité de point par période du signal d'entrée. Ce sous-échantillonnage, ou ré-échantillonnage, permet de former le signal SE apte à être traité par les modules suivants.

Une sortie du module de sous-échantillonnage 10 est reliée à une entrée d'un module 11 de calcul de transformée de Fourier sur le signal ré-échantillonné SE. Le module 10 délivre au module 11 le signal numérique alternatif ré-échantillonné SE comportant par exemple 48 points par période. Le module 11 effectue des calculs de transformée de Fourier sur le signal ré-échantillonné SE.

Une sortie du module 11 est reliée à une entrée d'un module 12 de calcul de fréquence du signal d'entrée S. Le module 12 détermine la fréquence F du signal d'entrée S par poursuite de deux phaseurs décalés d'une durée donnée. Ce calcul repose sur les calculs de transformée de Fourier réalisés par le module 11. La poursuite des deux phaseurs détermine un écart angulaire qui est l'image de la fréquence du signal d'entrée S.

En fait, l'écart angulaire est un indicateur sur l'adéquation entre fréquence du signal d'entrée et fréquence de sous-échantillonnage : on cherche à ce que l'écart angulaire soit égal à l'angle théorique correspondant à la durée donnée séparant les deux phaseurs, par exemple 180° si l'on a choisi deux phaseurs séparés d'une demi période. Si l'écart angulaire est différent de cet angle théorique, alors cela indique que la fréquence du signal d'entrée et fréquence de sous-échantillonnage ne sont plus en adéquation.

Par exemple, le calcul de la transformée de Fourier du signal d'entrée est effectué tous les quarts de période du signal d'entrée et la comparaison angulaire des deux phaseurs est effectuée sur deux phaseurs décalés d'une demi période du signal d'entrée, donc sur deux phaseurs qui sont en théorie en opposition de phase. Les phaseurs sont calculés sur une profondeur d'une période du signal d'entrée.

Le module 12 a ainsi une sortie qui fournit la fréquence F du signal d'entrée S.

Le module 12 a une autre sortie reliée à une entrée du module 10 de sous-échantillonnage.

Le module 12 compare la valeur courante de la fréquence du signal d'entrée avec la valeur précédente. En cas de modification de cette fréquence, le module 12 fournit une valeur modifiée de fréquence de sous-échantillonnage fd au module 10. En effet, comme exposé précédemment, la fréquence de sous-échantillonnage fd dépend de la fréquence F du signal d'entrée S, puisque que dans tous les cas, un signal numérique comportant 48 points par période doit être délivré en sortie du module 10.

Lorsque la fréquence de sous-échantillonnage fd est modifiée, les calculs pour la détermination de la fréquence F du signal d'entrée S sont effectués à partir de valeurs de signal ré-échantillonnés selon deux fréquences de sous-échantillonnage différentes pendant une période transitoire égale à la somme du décalage temporel entre deux phaseurs qui sont comparés et de la profondeur de calcul d'un phaseur. Selon l'exemple décrit, cette période transitoire a une longueur d'une période et demie du signal d'entrée S.

Pendant cette période transitoire, la différence d'angle entre phaseurs comporte une erreur, et par conséquent la mesure de fréquence F du signal d'entrée S comporte également une erreur. Il est à noter en outre que si un calcul de la dérivée de la fréquence du signal d'entrée est effectué, il comporte lui aussi une erreur. L'erreur sur la dérivée est plus importante que celle sur la fréquence elle-même. En particulier, l'erreur sur la dérivée de la fréquence dure plus longtemps que l'erreur sur la fréquence. En effet, la durée de l'erreur sur la dérivée est la somme de la durée de l'erreur sur la fréquence (1.5 période ici) et du décalage temporel existant entre les deux fréquences utilisées pour calculer la dérivée.

Selon un mode de réalisation préféré de la présente invention, représenté à la **figure 2****,** un dispositif de détermination de la fréquence d'un signal électrique alternatif comporte une entrée pour recevoir un signal d'entrée S sous la forme d'un signal numérique périodique échantillonné à une fréquence d'échantillonnage donnée, par exemple 4800 Hz. Le signal d'entrée S représente un signal électrique alternatif, qui peut être un courant électrique alternatif, ou une tension électrique alternative. On cherche à déterminer précisément la fréquence F de ce signal électrique alternatif.

En variante, la fréquence d'échantillonnage du signal peut être variable.

L'entrée du dispositif est reliée d'une part à une mémoire 20 et d'autre part à une entrée d'un commutateur 21. La mémoire 20 a une sortie reliée à une autre entrée du commutateur 21. La fonction du commutateur 21 sera exposée dans la suite.

La mémoire 20 est une mémoire tampon de type FIFO (First In First Out) et a pour fonction de mémoriser le signal numérique d'entrée S sur une fenêtre temporelle glissante qui est au moins égale à la somme du décalage temporel entre deux phaseurs qui sont comparés et de la profondeur de calcul d'un phaseur.

Une sortie du commutateur 21 est reliée à une entrée d'un module de sous-échantillonnage 22 qui réalise un sous-échantillonnage sur le signal numérique qu'il reçoit, soit le signal d'entrée S, soit le signal d'entrée mémorisé SM. Le sous-échantillonnage est asservi en fréquence et permet de passer d'un signal numérique échantillonné à une fréquence d'échantillonnage donnée, par exemple 4800 Hz, à un signal numérique ré-échantillonné SE, par exemple comportant 48 points par période. La fréquence de sous-échantillonnage fd dépend de la fréquence F du signal électrique alternatif, de sorte que le module 22 délivre un signal numérique alternatif ré-échantillonné SE comportant un nombre déterminé de points par période, par exemple 48 points par période.

En variante, le module 22 est un module d'interpolation et de sous-échantillonnage qui réalise une interpolation linéaire sur le signal numérique qu'il reçoit puis un sous-échantillonnage sur le signal interpolé. Dans ce cas, le module 22 délivre un signal numérique alternatif ré-échantillonné comportant un nombre déterminé de points par période, par exemple 48 points par période, mais les points peuvent être différents, aussi bien en amplitude que sur le plan temporel, des points du signal numérique d'entrée. Bien entendu, d'autres types d'interpolation sont envisageables.

Une sortie du module 22 est reliée à une entrée d'un module 23 de calcul de transformée de Fourier discrète sur le signal ré-échantillonné SE. Le module 22 délivre donc au module 23 le signal numérique alternatif ré-échantillonné SE, comportant un nombre déterminé de points par période, par exemple 48 points par période. Le module 23 effectue des calculs de transformée de Fourier sur le signal qu'il reçoit.

Une sortie du module 23 est reliée à une entrée d'un module 24 de calcul de fréquence F du signal d'entrée S. Le module 24 détermine la fréquence du signal d'entrée par poursuite de deux phaseurs décalés d'une durée donnée. Ce calcul repose sur les calculs de transformée de Fourier réalisés par le module 23. La poursuite des deux phaseurs détermine un écart angulaire qui est l'image de la fréquence F du signal d'entrée. Ce calcul est classique est n'est pas détaillé ici.

En fait, l'écart angulaire est un indicateur sur l'adéquation entre fréquence du signal d'entrée et fréquence de sous-échantillonnage : on cherche à ce que l'écart angulaire soit égal à l'angle théorique correspondant à la durée donnée séparant les deux phaseurs, par exemple 180° si l'on a choisi deux phaseurs séparés d'une demi période. Si l'écart angulaire est différent de cet angle théorique, alors cela indique que la fréquence du signal d'entrée et fréquence de sous-échantillonnage ne sont plus en adéquation.

Par exemple, le calcul de la transformée de Fourier du signal d'entrée est effectué tous les quarts de période du signal d'entrée et la comparaison angulaire des deux phaseurs est effectuée sur deux phaseurs décalés d'une demi période du signal d'entrée, donc sur deux phaseurs qui sont en théorie en opposition de phase. Les phaseurs sont calculés sur une profondeur d'une période du signal d'entrée.

Le module 24 a ainsi une sortie qui fournit la fréquence F du signal électrique alternatif S. En variante, le module 24 calcule la dérivée première et éventuellement les dérivées successives de la fréquence du signal, par des calculs classiques.

Le module 24 a une autre sortie reliée à une entrée du module 22 de sous-échantillonnage. Le module 24 compare la valeur courante de la fréquence du signal électrique alternatif avec la valeur précédente. Deux valeurs sont considérées comme identiques si leur différence est inférieure à un seuil prédéterminé. En cas de modification de cette fréquence, le module 24 fournit une valeur modifiée de fréquence de sous-échantillonnage fd au module 22. En effet, la fréquence de sous-échantillonnage dépend de la fréquence du signal d'entrée puisque le but du module 22 est de délivrer un signal ayant un nombre donné de points par période du signal d'entrée.

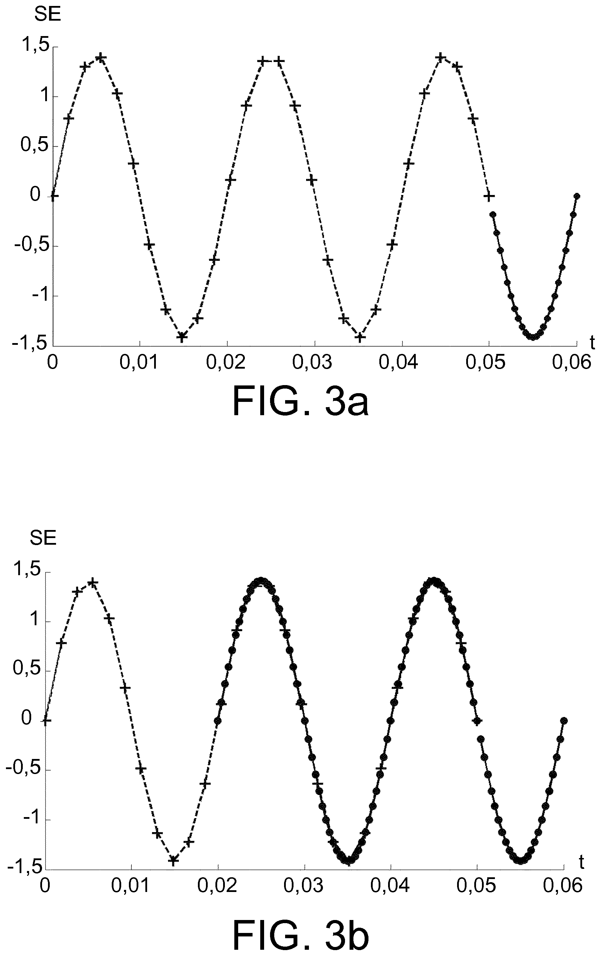

La **figure 3a** représente de manière schématique le signal ré-échantillonné SE en sortie du module de sous-échantillonnage 22, avant exploitation du signal mémorisé SM. Entre les instants t=0 et t=0.05 s, le signal est ré-échantillonné avec une première fréquence de sous-échantillonnage, ce qui produit une suite de points représentés par des croix.

A l'instant t=0.05 s, le module 24 de calcul de fréquence du signal d'entrée détermine que la fréquence F du signal est modifiée. La fréquence de sous-échantillonnage fd est modifiée en conséquence. Le signal est alors ré-échantillonné avec une seconde fréquence de sous-échantillonnage, à partir de l'instant t=0.05 s, ce qui produit une suite de points représentés par des ronds. On suppose ici que le signal d'entrée mémorisé SM n'a pas encore été exploité.

Il est à noter que pour mieux représenter le changement de fréquence de sous-échantillonnage, les fréquences de sous-échantillonnage avant et après l'instant t=0.05 s ont été choisies très différentes dans la figure 3a.

La **figure 3b** représente de manière schématique le signal ré-échantillonné en sortie du module de sous-échantillonnage 22, toujours avec un changement de fréquence de signal d'entrée à t=0,05 s, mais cette fois après exploitation du signal d'entrée mémorisé SM.

Lorsque la fréquence de sous-échantillonnage est modifiée, le commutateur 21 est commandé de manière à relier la mémoire 20 au module de sous-échantillonnage 22. Le sous-échantillonnage est alors réalisé sur le signal mémorisé SM, mais avec la nouvelle valeur de fréquence de sous-échantillonnage. Le signal mémorisé est le signal numérique d'entrée, sur une durée au moins égale à la somme du décalage temporel entre deux phaseurs qui sont comparés et de la profondeur de calcul d'un phaseur soit dans l'exemple décrit au moins une période et demie. Le sous-échantillonnage est donc effectué rétroactivement, sur au moins une période et demie du signal d'entrée à partir de l'instant t=0.05 secondes.

Ainsi la poursuite des deux phaseurs est effectuée à partir de données représentant le signal d'entrée ré-échantillonné à une même fréquence d'échantillonnage et la fréquence du signal d'entrée qui est déterminée par le module 24 est correctement calculée.

Lorsque le signal d'entrée mémorisé SM a remplacé le signal d'entrée S sur une durée correspondant à la fenêtre temporelle de la mémoire 20, et que la fréquence F mesurée par le module 24 est stable, le commutateur 21 est basculé et le signal S est à nouveau fourni en entrée du module 22.

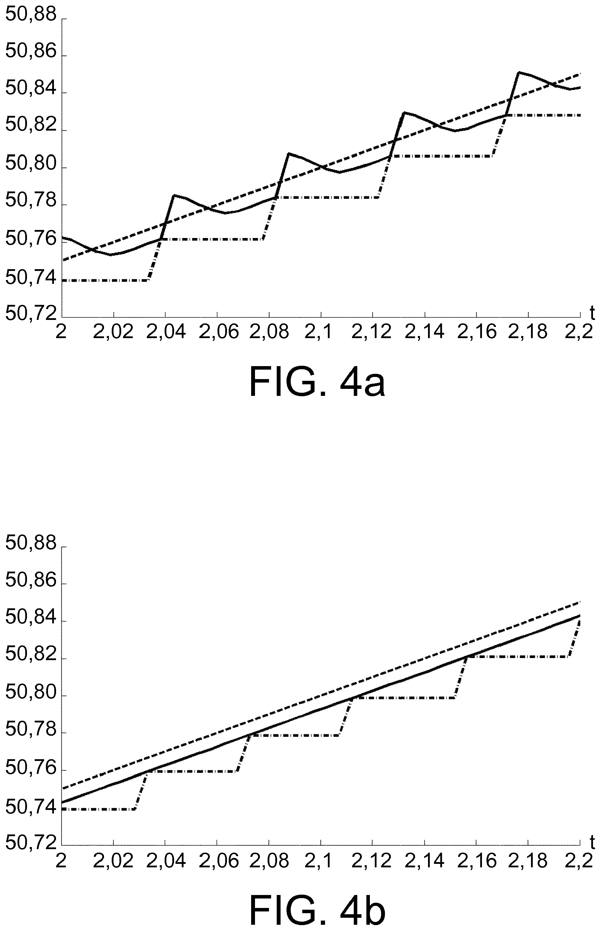

La **figure 4a** représente un exemple de variation de la fréquence du signal électrique alternatif, selon la technique antérieure. Dans cet exemple, la fréquence réelle du signal alternatif varie linéairement selon une pente de 0,5 Hz par seconde, pour les besoins de la démonstration. Elle est représentée par une droite en traits pointillés.

La fréquence de sous-échantillonnage à un facteur multiplicatif près est sensiblement en marche d'escalier. Elle est représentée en traits alternés.

La fréquence mesurée du signal électrique alternatif est représentée en trait continu. On constate que chaque changement de fréquence de sous-échantillonnage a pour résultat que la fréquence mesurée du signal électrique alternatif est erronée sur environ une période et demie du signal électrique.

La **figure 4b** représente un exemple de variation de la fréquence du signal électrique alternatif, selon la présente invention. Afin de comparer avec la figure précédente, là aussi la fréquence réelle du signal alternatif varie linéairement selon une pente de 0,5 Hz par seconde. Elle est représentée par une droite en traits pointillés.

La fréquence de sous-échantillonnage à un facteur multiplicatif près est sensiblement en marche d'escalier. Elle est représentée en traits alternés.

La fréquence mesurée du signal électrique alternatif est représentée en trait continu. On constate qu'elle varie linéairement comme la fréquence réelle du signal alternatif et qu'elle suit la même pente que la fréquence réelle du signal alternatif.

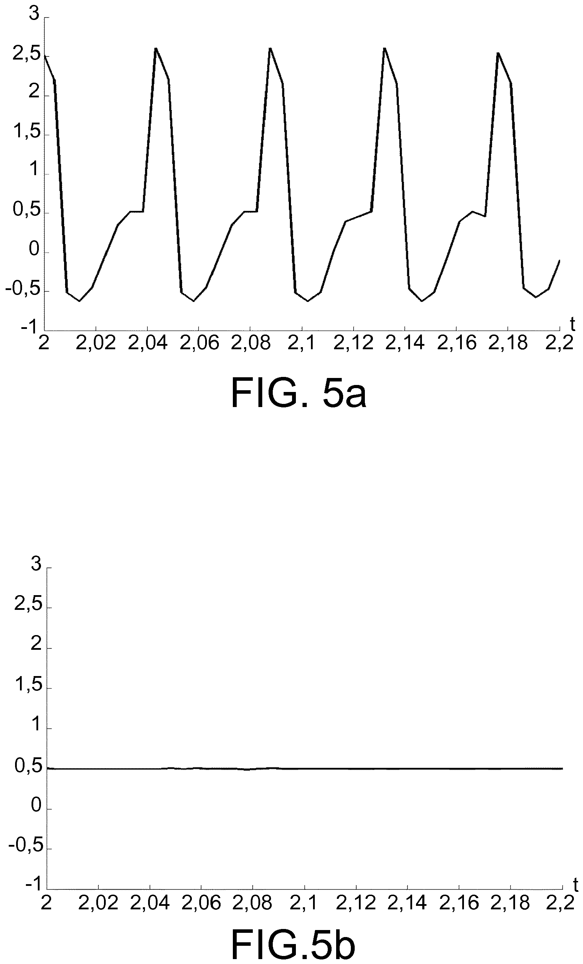

La **figure 5a** représente un exemple de variation de la dérivée de la fréquence du signal électrique alternatif, selon la technique antérieure. Il s'agit de la dérivée de la fréquence représentée à la figure 4a.

La **figure 5b** représente un exemple de variation de la dérivée de la fréquence du signal électrique alternatif, selon la présente invention. Il s'agit de la dérivée de la fréquence représentée à la figure 5a.

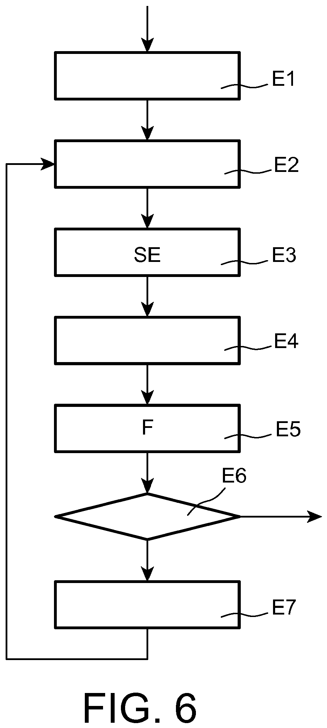

La **figure 6** représente le fonctionnement du dispositif de détermination de la fréquence d'un signal électrique alternatif, sous la forme d'un organigramme comportant des étapes E1 à E7.

L'étape E1 est la mémorisation dans une mémoire tampon de type FIFO (First In First Out) du signal numérique d'entrée S sur une fenêtre temporelle glissante qui est au moins égale à la somme du décalage temporel entre deux phaseurs qui sont comparés et de la profondeur de calcul d'un phaseur.

L'étape suivante E2 est une sélection de signal à traiter. Comme détaillé dans la suite, le signal à traiter est soit le signal numérique d'entrée S, soit le signal mémorisé SM. Par défaut, le signal à traiter est le signal numérique d'entrée S.

L'étape suivante E3 est un sous-échantillonnage du signal numérique sélectionné à l'étape précédente. La fréquence de sous-échantillonnage fd dépend de la fréquence F du signal électrique alternatif S, de sorte que l'étape E3 a pour résultat un signal numérique alternatif ré-échantillonné SE comportant un nombre déterminé de points par période, par exemple 48 points par période.

En variante, l'étape E3 est une interpolation linéaire sur le signal numérique sélectionné à l'étape précédente puis un sous-échantillonnage sur le signal interpolé. Dans ce cas, le résultat de l'étape E3 est un signal numérique alternatif ré-échantillonné comportant un nombre déterminé de points par période, par exemple 48 points par période, mais les points peuvent être différents des points du signal numérique d'origine. Bien entendu, d'autres types d'interpolation sont envisageables.

L'étape suivante E4 est un calcul de transformée de Fourier discrète sur le signal ré-échantillonné à l'étape précédente.

L'étape suivante E5 est un calcul de fréquence F du signal d'entrée S. La fréquence du signal numérique d'entrée est déterminée par poursuite de deux phaseurs décalés d'une durée donnée. Ce calcul repose sur les calculs de transformée de Fourier réalisés à l'étape précédente. La poursuite des deux phaseurs détermine un écart angulaire qui est l'image de la fréquence du signal numérique d'entrée.

Par exemple, le calcul de la transformée de Fourier du signal numérique d'entrée est effectué tous les quarts de période du signal numérique et la comparaison angulaire des deux phaseurs est effectuée sur deux phaseurs décalés d'une demi période du signal numérique, donc sur deux phaseurs qui sont en théorie en opposition de phase. Les phaseurs sont calculés sur une profondeur d'une période du signal numérique.

L'étape E5 a pour résultat la fréquence F du signal d'entrée S. En variante, l'étape E5 comporte aussi le calcul de la dérivée première et éventuellement des dérivées successives de la fréquence du signal d'entrée, par des calculs classiques.

L'étape suivante E6 est un test pour déterminer si la valeur courante de la fréquence du signal d'entrée est ou non identique à la valeur précédente. Deux valeurs sont considérées comme identiques si leur différence est inférieure à un seuil prédéterminé.

Si la valeur courante de la fréquence du signal électrique alternatif S est identique à la valeur précédente, alors les traitements se poursuivent sans modification.

Si la valeur courante de la fréquence du signal électrique alternatif S est différente de la valeur précédente, alors l'étape E6 est suivie de l'étape E7 à laquelle une valeur modifiée de fréquence de sous-échantillonnage remplace la valeur courante de fréquence de sous-échantillonnage. En effet, la fréquence de sous-échantillonnage dépend de la fréquence du signal numérique d'entrée puisque le but de l'étape E3 est de délivrer un signal ayant un nombre donné de points par période du signal d'entrée.

L'étape E7 est suivie de l'étape E2 à laquelle le signal sélectionné est cette fois le signal mémorisé SM.

L'étape E2 est ensuite suivie de l'étape E3, à laquelle le sous-échantillonnage est réalisé sur le signal mémorisé SM, avec la valeur modifiée de fréquence de sous-échantillonnage. Le signal mémorisé est le signal numérique d'entrée, mémorisé sur une durée au moins égale à la somme du décalage temporel entre deux phaseurs qui sont comparés et de la profondeur de calcul d'un phaseur, soit dans l'exemple décrit au moins une période et demie du signal numérique d'entrée S. Le sous-échantillonnage est donc effectué rétroactivement, sur une période et demie du signal d'entrée.

Ainsi la poursuite des deux phaseurs est effectuée à partir de données représentant le signal à une même fréquence d'échantillonnage et la fréquence du signal d'entrée qui est déterminée à l'étape E5 est correctement calculée.

Lorsque le signal mémorisé SM a remplacé le signal d'entrée S sur une durée correspondant à la fenêtre temporelle de la mémoire 20, et que la fréquence F déterminée à l'étape E5 est stable, le signal d'entrée S est à nouveau sélectionné à l'étape E2.

Les étapes E1 à E7 précédemment décrites sont répétées en boucle, de sorte que, par exemple, les calculs de transformée de Fourier soient effectués tous les quarts de période du signal d'entrée et la poursuite de phaseurs soit effectuée toutes les demi périodes du signal d'entrée.

Il est à noter que les calculs supplémentaires effectués sur le signal d'entrée mémorisé n'introduisent pas de retard dans la réponse du système vu de l'extérieur. En effet, les temps de calculs supplémentaires sont faibles, par exemple par rapport à la période d'un courant de réseau électrique. En pratique, la fréquence calculée du signal d'entrée est publiée une fois par période, alors que comme on l'a vu, les calculs sont effectués tous les quarts de période. Il est possible de publier la fréquence calculée du signal d'entrée toutes les demi-périodes ou tous les quarts de période, sans introduction de retard. Il en va de même pour les dérivées de la fréquence.

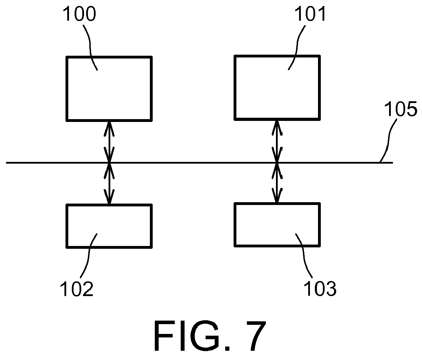

La **figure 7** représente un mode de réalisation particulier de dispositif de détermination de la fréquence d'un signal électrique alternatif, selon l'invention.

Le dispositif de détermination de la fréquence d'un signal électrique alternatif a la structure générale d'un ordinateur. Il comporte notamment un processeur 100 exécutant un programme d'ordinateur mettant en oeuvre le procédé selon l'invention, une mémoire 101, une interface d'entrée 102 et une interface de sortie 103.

Ces différents éléments sont classiquement reliés par un bus 105.

L'interface d'entrée 102 est reliée à des moyens classiques de mesure de signal électrique et est destinée à recevoir le signal d'entrée.

Le processeur 100 exécute les traitements précédemment exposés. Ces traitements sont réalisés sous la forme d'instructions de code du programme d'ordinateur qui sont mémorisées par la mémoire 101 avant d'être exécutées par le processeur 100.

La mémoire 101 mémorise en outre le signal d'entrée.

L'interface de sortie 103 délivre la fréquence du signal d'entrée.

## Revendications

1. Procédé de détermination de la fréquence d'un signal d'entrée alternatif, comportant les étapes de :
Echantillonnage (E3) du signal d'entrée à une première fréquence d'échantillonnage (fd),
Premier calcul et première comparaison angulaire (E4, E5) de deux phaseurs représentant le signal d'entrée à deux instants respectifs décalés d'une durée prédéterminée, en fonction du signal d'entrée échantillonné à la première fréquence d'échantillonnage,
Estimation (E5) de la fréquence du signal d'entrée en fonction du résultat de la comparaison angulaire des deux phaseurs calculés,
**caractérisé en ce qu'**il comporte en outre les étapes de :
Mémorisation (E1) du signal d'entrée,
Recherche (E6) d'une modification de fréquence du signal d'entrée,
et en cas de détection d'une modification de fréquence du signal d'entrée,
Détermination (E7) d'une seconde fréquence d'échantillonnage, en fonction de la fréquence modifiée du signal d'entrée,
Echantillonnage (E3) du signal d'entrée mémorisé avec la seconde fréquence d'échantillonnage, sur une fenêtre temporelle précédant l'instant de détection de modification de fréquence,
Second calcul et seconde comparaison angulaire (E4, E5) de deux phaseurs représentant le signal d'entrée, à deux instants respectifs décalés de la durée prédéterminée, en fonction du signal d'entrée échantillonné à la seconde fréquence d'échantillonnage et du signal d'entrée mémorisé échantillonné à la seconde fréquence d'échantillonnage,
Estimation (E5) de la fréquence du signal d'entrée en fonction du résultat de la seconde comparaison angulaire des deux phaseurs calculés.

2. Procédé de détermination de la fréquence d'un signal électrique alternatif selon la revendication 1, **caractérisé en ce que** la mémorisation du signal d'entrée est effectuée sur une fenêtre temporelle glissante d'une durée au moins égale à la somme du décalage temporel entre deux phaseurs qui sont comparés et de la profondeur de calcul d'un phaseur.

3. Procédé de détermination de la fréquence d'un signal électrique alternatif selon la revendication 1 ou 2, **caractérisé en ce que** la recherche d'une modification de fréquence du signal d'entrée comporte le calcul d'une différence entre deux valeurs successives de la fréquence estimée du signal d'entrée, et la comparaison de la différence calculée à un seuil.

4. Procédé de détermination de la fréquence d'un signal électrique alternatif selon l'une quelconque des revendications 1 à 3, **caractérisé en ce qu'**il comporte en outre le calcul de la dérivée de la fréquence du signal.

5. Procédé de détermination de la fréquence d'un signal électrique alternatif selon l'une quelconque des revendications 1 à 4, **caractérisé en ce que** la durée prédéterminée pour le calcul et la comparaison de deux phaseurs est d'une demi-période du signal d'entrée.

6. Procédé de détermination de la fréquence d'un signal électrique alternatif selon l'une quelconque des revendications 1 à 5, **caractérisé en ce que** le calcul et la comparaison de deux phaseurs sont effectués tous les quarts de période du signal d'entrée.

7. Procédé de détermination de la fréquence d'un signal électrique alternatif selon l'une quelconque des revendications 1 à 6, **caractérisé en ce que** le signal d'entrée représente le courant ou la tension d'un réseau d'alimentation électrique.

8. Procédé de détermination de la fréquence d'un signal électrique alternatif selon l'une quelconque des revendications 1 à 6, **caractérisé en ce que** le signal d'entrée représente une composante de courant ou de tension d'un réseau d'alimentation électrique, cette composante étant issue d'une transformation matricielle du courant ou de la tension du réseau d'alimentation électrique.

9. Dispositif de détermination de la fréquence d'un signal d'entrée alternatif, comportant :
Des moyens (22) d'échantillonnage du signal d'entrée à une première fréquence d'échantillonnage,
Des moyens (23, 24) de premier calcul et première comparaison angulaire de deux phaseurs représentant le signal d'entrée à deux instants respectifs décalés d'une durée prédéterminée, en fonction du signal d'entrée échantillonné à la première fréquence d'échantillonnage,
Des moyens (24) d'estimation de la fréquence du signal d'entrée en fonction du résultat de la comparaison angulaire des deux phaseurs calculés,
**caractérisé en ce qu'**il comporte en outre :
Des moyens (20) de mémorisation du signal d'entrée,
Des moyens (24) de recherche d'une modification de fréquence du signal d'entrée,
Des moyens (24) de détermination d'une seconde fréquence d'échantillonnage, en fonction de la fréquence modifiée du signal d'entrée, en cas de détection d'une modification de fréquence du signal d'entrée,
Des moyens (22) d'échantillonnage du signal d'entrée mémorisé avec la seconde fréquence d'échantillonnage, sur une fenêtre temporelle précédant l'instant de détection de modification de fréquence,
Des moyens (23, 24) de second calcul et seconde comparaison angulaire de deux phaseurs représentant le signal d'entrée, à deux instants respectifs décalés de la durée prédéterminée, en fonction du signal d'entrée échantillonné à la seconde fréquence d'échantillonnage et du signal d'entrée mémorisé échantillonné à la seconde fréquence d'échantillonnage,
Des moyens (24) d'estimation de la fréquence du signal d'entrée en fonction du résultat de la seconde comparaison angulaire des deux phaseurs calculés.

10. Relais de protection **caractérisé en ce qu'**il comporte le dispositif de détermination de la fréquence d'un signal d'entrée alternatif selon la revendication 9.

11. Equipement de télé-conduite de réseau de distribution électrique **caractérisé en ce qu'**il comporte le dispositif de détermination de la fréquence d'un signal d'entrée alternatif selon la revendication 9.

12. Programme d'ordinateur comportant des instructions pour l'exécution des étapes du procédé selon l'une quelconque des revendications 1 à 8 lorsque ledit programme est exécuté par un ordinateur.

13. Support d'enregistrement lisible par un ordinateur sur lequel est enregistré un programme d'ordinateur comprenant des instructions pour l'exécution des étapes du procédé selon l'une quelconque des revendications 1 à 8.
